# FASCICULE DE BREVET EUROPEEN

(11) **EP 2 133 919 B1**
(45) Date de publication et mention de la délivrance du brevet: **12.01.2011**
(21) Numéro de dépôt: 09162258.9
(22) Date de dépôt: 09.06.2009
(51) Int. Cl.: H01L 29/786, H01L 21/336

(54) **Procédé de fabrication d'un transistor SOI à plan de masse et grille auto alignés et avec oxyde enterré d'epaisseur variable**
Herstellungsverfahren von einem SOI-Transistor mit selbstjustierter Grundplatte und Gate und mit einer vergrabenen Oxidschicht mit veränderlicher Dicke
Method for manufacturing an SOI transistor with ground plane and gate being self-aligned and with a buried oxide of varying thickness

(30) Priorité: 11.06.2008 FR 0853868
(43) Date de publication de la demande: 16.12.2009
(73) Titulaire: Commissariat à l'Énergie Atomique et aux Énergies Alternatives, 75015 Paris (FR)
(72) Inventeur: Fenouillet-Beranger, Claire, 38100, GRENOBLE (FR); Coronel, Philippe, 38350, BARRAUX (FR)
(74) Mandataire: Ilgart, Jean-Christophe

(56) Documents cités:
- US-A- 6 072 217
- US-A1- 2004 197 977
- US-A1- 2005 158 933
- US-A1- 2007 102 761
- US-A1- 2007 148 839
- YIONG W ET AL: "Self-aligned ground-plane fdsoi mosfet" 2002 IEEE INTERNATIONAL SOI CONFERENCE PROCEEDINGS. WILLIAMSBURG, VA, OCT. 7 - 10, 2002; [IEEE INTERNATIONAL SOI CONFERENCE], NEW YORK, NY : IEEE, US, 7 octobre 2002 (2002-10-07), pages 23-24, XP010610992 ISBN: 978-0-7803-7439-3
- DICKS M.H. ET AL.: "A test chip to characterise P-MOS transistors produced using a novel organometallic material" IEEE PROCEEDINGS OF THE 2004 INTERNATIONAL CONFERENCE ON MICROELECTRONIC TEST STRUCTURES, vol. 17, 22 mars 2004 (2004-03-22), - 25 mars 2004 (2004-03-25) pages 183-187, XP002514911

## Description

### DOMAINE TECHNIQUE

L'invention concerne un transistor à oxyde enterré d'épaisseur variable, et comportant une grille et un plan de masse auto-alignés. L'invention concerne également un procédé de réalisation d'un tel transistor. L'invention s'applique notamment aux transistors SOI (silicium sur isolant) à déplétion totale, pouvant par exemple être utilisés pour la réalisation de dispositifs logiques faible puissance (« low operating power ») et hautes performances, de mémoires à 1 transistor ou de dispositifs analogiques RF (Radio Fréquences).

### ÉTAT DE LA TECHNIQUE ANTÉRIEURE

La course à la réduction des dimensions des transistors implique de nouvelles contraintes à prendre en compte pour la réalisation des transistors. Un des problèmes majeurs liés à la miniaturisation des transistors MOSFET est l'effet de canal court.

Pour la réalisation de transistors SOI conformes aux contraintes du noeud technologique 32 nm, l'utilisation d'un oxyde enterré mince et d'un plan de masse dopé formé sous cet oxyde enterré permet de contrôler en partie les effets de canaux courts.

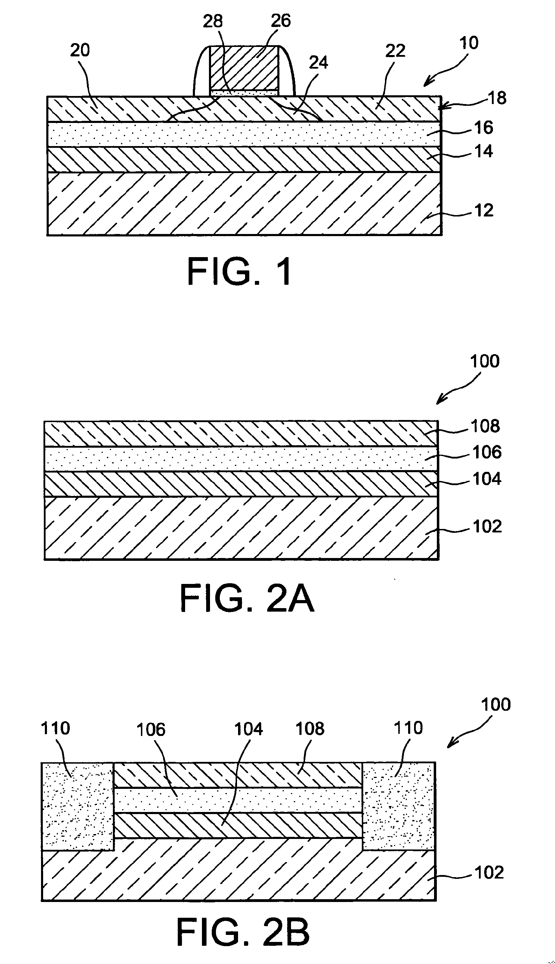

La figure 1 représente un exemple d'un tel transistor 10. Ce transistor 10 est de type FD-SOI (SOI à déplétion totale) et comporte un substrat 12 à base de silicium sur lequel sont empilés un plan de masse métallique 14 dont la densité volumique de dopants est comprise entre environ 5.10¹⁸ cm⁻³ et 10²¹ cm⁻³, une couche mince d'oxyde enterré 16 d'épaisseur égale à environ 10 nm, et une couche mince de silicium 18 d'épaisseur égale à environ 5 nm dans laquelle sont formées ou non des zones dopées de source 20, de drain 22 et de canal 24. Une grille 26 de longueur par exemple égale à environ 20 nm et un oxyde de grille 28 d'épaisseur égale à environ 1 nm sont réalisés sur la couche mince de silicium 18.

Toutefois, un tel plan de masse formé sur toute la longueur du transistor a notamment pour inconvénient d'augmenter les capacités de jonctions source-substrat et drain-substrat du transistor.

Pour palier à cet inconvénient, il est décrit dans le document « Self-Aligned Ground-Plane FDSOI MOSFET » de W. Xiong et al., IEEE International SOI Conference, 2002, pages 23 et 24, de réaliser un plan de masse par implantation de dopants (densité égale à environ 5.10¹⁸ cm⁻³) dans le substrat et localisé sous la grille du transistor.

Ainsi, on réduit les effets de canaux courts tout en atténuant l'augmentation des capacités de jonctions. Mais cette amélioration ne permet pas d'obtenir un transistor dont les performances dynamiques soient satisfaisantes. De plus, le procédé de réalisation d'un tel transistor décrit dans le document indiqué ci-dessus implique la mise en oeuvre d'étapes de photolithographie dédiées uniquement à la réalisation du plan de masse, augmentant sensiblement le coût de réalisation d'un tel transistor.

Le document US 2004/197977 A1 décrit un procédé de réalisation d'un transistor à double grilles auto-alignées, dans lequel la grille arrière est réalisée par une implantation de dopants dans une partie d'une couche de matériau métallique ou semi-conducteur, et dans lequel des portions diélectriques sont réalisées autour de la grille arrière.

### EXPOSÉ DE L'INVENTION

Un but de la présente invention est de proposer un procédé aboutissant à un transistor, par exemple de type SOI, impliquant de faibles effets de canaux courts tout en réduisant les capacités de jonctions présentées par ce transistor, et présentant de bonnes performances dynamiques.

Pour cela, il est proposé de réaliser un transistor à grille et plan de masse auto-alignés, comportant au moins :
- un substrat à base d'au moins un semi-conducteur,
- une portion de matériau organométallique dont une première face est disposée en regard d'une face du substrat, formant le plan de masse du transistor,
- une couche à base d'au moins un matériau diélectrique dont une première face est disposée contre une seconde face de la portion de matériau organométallique opposée à la première face de la portion de matériau organométallique,
- des portions diélectriques disposées entre la face du substrat et la première face de la couche diélectrique, autour de la portion de matériau organométallique,
la forme et les dimensions d'une section, dans un plan sensiblement parallèle à la face du substrat, de la grille du transistor étant sensiblement égales à la forme et aux dimensions d'une section de la portion de matériau organométallique dans ledit plan.

Un tel transistor comporte ainsi un plan de masse formé par la portion de matériau organométallique sur le substrat et entouré d'un oxyde enterré d'épaisseur variable formé par la couche diélectrique et les portions diélectriques réalisées autour de la portion de matériau organométallique. L'oxyde d'épaisseur variable associé à un tel plan de masse permet de contrôler les effets de canaux courts tout en améliorant les performances dynamiques du transistor liées à la réduction des capacités de jonctions source-substrat et drain-substrat de ce transistor par rapport à ceux de l'art antérieur (baisse de la puissance dynamique consommée et du temps de propagation).

De part son plan de masse formé par une portion de matériau organométallique, un tel dispositif peut donc avoir un canal non dopé du fait que ce plan de masse ne soit pas réalisé par implantation.

De plus, un tel dispositif permet d'obtenir des jonctions source/substrat et drain/substrat parfaitement contrôlées vis-à-vis de l'isolation.

Le plan de masse du dispositif peut également remplir d'autres fonctions. Le dispositif permet en outre de réaliser une dissymétrie entre les zones de source et de drain (dissymétries de dopage et/ou géométriques) en réalisant des injections différentes entre les zones de source et de drain.

Enfin, en fonction des matériaux disposés autour de la portion organométallique (siliciuration « all around », contact « all around »), il est possible de réaliser une polarisation arrière de la grille, de la source ou encore du drain. Le ou les matériaux diélectriques présents autour de la portion organométalliques permettent de former un oxyde enterré d'épaisseur variable.

Les matériaux disposés autour de la portion de matériau organométallique peuvent être différents, ou de natures différentes, d'un côté et de l'autre de la portion de matériau organométallique, notamment dans le cas de systèmes asymétriques.

Le matériau organométallique peut être à base de platine et/ou de palladium.

Les portions diélectriques peuvent être à base d'oxyde de silicium et/ou de nitrure de silicium.

L'épaisseur de la couche diélectrique peut être comprise entre environ 3 nm et 60 nm ou entre 10 nm et 50 nm. De plus, l'épaisseur des portions diélectriques peut être fonction de l'application envisagée : mémoire ONO (oxyde-nitrure-oxyde), impact sur injection, ..., et peut notamment être comprise entre environ 10 nm et 100 nm. Il est donc possible de réaliser un transistor remplissant plusieurs fonctions en fonction du diélectrique de grille utilisé qui est indépendant des portions diélectriques se trouvant autour de la portion de matériau organométallique formant le plan de masse du transistor (par exemple une fonction mémoire réalisée par les portions diélectriques autour du plan de masse et fonction logique réalisée par la grille du transistor, ou inversement).

L'épaisseur de la portion de matériau organométallique peut être comprise entre environ 10 nm et 100 nm.

Le transistor peut comporter en outre une couche à base d'au moins un semi-conducteur, dont une première face peut être disposée contre une seconde face de la couche de matériau diélectrique opposée à la première face de la couche de matériau diélectrique, dans laquelle peuvent être formées ou non des zones dopées de canal, de source et de drain, la grille du transistor pouvant être disposée du côté d'une seconde face de la couche de semi-conducteur opposée à la première face de la couche de semi-conducteur.

Le transistor peut comporter en outre des espaceurs formés autour de la grille à partir d'au moins deux couches à base de matériaux diélectriques différents, les portions diélectriques pouvant être à base desdits matériaux diélectriques différents. Les espaceurs peuvent être formés à partir de premières parties des deux couches de matériaux diélectriques différents, les portions diélectriques pouvant être formées à partir de secondes parties des deux couches de matériaux diélectriques.

Le transistor peut comporter en outre un contact relié électriquement à la portion de matériau organométallique et pouvant traverser au moins la couche diélectrique et la grille du transistor.

La première face de la portion de matériau organométallique peut être disposée contre la face du substrat.

Dans une variante, le transistor peut comporter en outre une seconde couche à base d'au moins un matériau diélectrique disposée entre la première face de la portion de matériau organométallique et le substrat, et entre les portions diélectriques et le substrat.

L'invention concerne un procédé de réalisation d'un transistor à grille et plan de masse auto-alignés, comportant au moins les étapes de :
a) réalisation d'un empilement, sur une face d'un substrat à base d'au moins un semi-conducteur, comprenant au moins une couche à base d'au moins un matériau organométallique et une couche à base d'au moins un matériau diélectrique disposée sur la couche organométallique (104, 204) et destinée à former une couche isolante enterrée du transistor (100, 200),
b) insolation par faisceaux d'électrons d'au moins une partie de la couche organométallique, une portion de la couche organométallique distincte de la partie insolée de la couche organométallique et destinée à former le plan de masse du transistor étant protégée des faisceaux d'électrons par un masque, par exemple formé par la grille du transistor, durant cette étape d'insolation, la forme et les dimensions d'une section, dans un plan sensiblement parallèle à la face du substrat, de la grille du transistor étant destinées à être sensiblement égales à la forme et aux dimensions d'une section de ladite portion de matériau organométallique dans ledit plan,
c) retrait de la partie insolée de la couche organométallique.

Le procédé selon l'invention comporte egalement une étape d) de réalisation de portions diélectriques dans des emplacements vides formés par le retrait de ladite partie insolée de la couche organométallique, entre la face du substrat et la couche diélectrique, autour de ladite portion de la couche organométallique.

Un tel procédé permet de réaliser un transistor SOI à plan de masse et grille auto-alignés, et comportant un oxyde enterré d'épaisseur variable, ne nécessitant pas la mise en oeuvre d'étapes de photolithographie spécifiques à la réalisation de l'oxyde enterré d'épaisseur variable.

Le matériau organométallique sert ici à la fois pour réaliser le plan de masse du transistor, ainsi que pour former un matériau sélectivement retirable utilisé pour la réalisation de l'oxyde enterré d'épaisseur variable.

Enfin, grâce au débordement du plan de masse sous l'ensemble de la grille du transistor, il est possible de réaliser un contact relié électriquement au plan de masse sans étape de photolithographie supplémentaire.

De plus, de part l'étape de retrait de la partie insolée de la couche organométallique, il est possible de former différents types de portions diélectriques dans les cavités autour du plan de masse réalisé (présence de siliciure pour réaliser une siliciuration « all around » et/ou également de contacts source - drain optimisant les surfaces de contact avec les zones de source et drain par rapport à des contacts source-drain classiques réalisés au-dessus des zones de source et de drain). Les matériaux disposés dans les creux peuvent également être de tout type, et dépendent des fonctions qui sont destinées à être réalisées par le transistor.

L'empilement réalisé à l'étape a) peut comporter en outre une couche à base d'au moins un semi-conducteur telle que la couche diélectrique puisse être disposée entre ladite couche de semi-conducteur et la couche organométallique.

Le procédé peut comporter en outre, entre l'étape a) de réalisation de l'empilement et l'étape b) d'insolation, une étape de réalisation de la grille du transistor sur la couche de semi-conducteur, la grille pouvant former le masque protégeant la portion de la couche organométallique durant l'étape b) d'insolation.

Le procédé peut comporter en outre, entre l'étape de réalisation de la grille du transistor et l'étape b) d'insolation, une étape de dépôt d'une couche de résine photosensible au moins sur la grille et sur la couche de semi-conducteur, et une étape de planarisation mécano-chimique de la couche de résine avec arrêt sur la grille. Ladite couche de résine insolée peut être transformée ensuite par recuit en matériau diélectrique après l'étape b) d'insolation.

Dans une variante, le procédé peut comporter en outre, entre l'étape a) de réalisation de l'empilement et l'étape b) d'insolation, une étape de dépôt d'une couche de résine photosensible au moins sur la couche de semi-conducteur de l'empilement, l'étape b) pouvant réaliser également l'insolation d'une partie de la couche de résine photosensible. La partie insolée de la couche de résine peut ensuite être transformée en matériau diélectrique.

Dans ce cas, le procédé peut comporter en outre, entre l'étape b) d'insolation et l'étape c) de retrait de la partie insolée de la couche organométallique, une étape de retrait de la partie insolée de la couche de résine photosensible pouvant ainsi former, dans la couche de résine, un creux, puis la réalisation de la grille par au moins une étape de dépôt d'au moins un matériau de grille dans ledit creux et sur la couche de résine et une étape de planarisation mécano-chimique avec arrêt sur la couche de résine.

Le procédé peut comporter en outre, entre l'étape de planarisation mécano-chimique et l'étape c) de retrait de la partie insolée de la couche organométallique, une étape de retrait de la partie insolée de la couche de résine.

L'empilement réalisé à l'étape a) peut comporter en outre une couche de résine photosensible telle que la couche de semi-conducteur puisse être disposée entre ladite couche de résine et la couche diélectrique.

Le procédé peut comporter en outre, entre l'étape a) de réalisation de l'empilement et l'étape b) d'insolation, une étape de réalisation du masque destiné à protéger la portion de la couche organométallique durant l'étape b) d'insolation, sur la couche de résine photosensible.

L'étape b) d'insolation peut également réaliser l'insolation d'une partie de la couche de résine photosensible, une portion de la couche de résine photosensible, distincte de ladite partie de la couche de résine photosensible, pouvant être protégée des faisceaux d'électrons par le masque, par exemple formé par la grille du transistor, durant cette étape d'insolation, la forme et les dimensions d'une section, dans un plan sensiblement parallèle à la face du substrat, de la grille du transistor pouvant être sensiblement égales à la forme et aux dimensions d'une section de ladite portion de la couche de résine photosensible dans ledit plan.

Le procédé peut comporter en outre, entre l'étape b) d'insolation et l'étape c) de retrait de la partie insolée de la couche organométallique, une étape de retrait de la partie non insolée de la couche de résine photosensible.

Le procédé peut comporter en outre, entre l'étape de retrait de la partie non insolée de la couche de résine photosensible et l'étape c) de retrait de la partie insolée de la couche organométallique, une étape de réalisation d'au moins un espaceur contre des parois latérales d'un creux formé dans la couche de résine par le retrait de la partie non insolée de la couche de résine, cet espaceur pouvant être destiné à former un contour de la grille du transistor.

Le procédé peut comporter en outre, entre l'étape de réalisation de l'espaceur dans le creux formé dans la couche de résine et l'étape c) de retrait de la partie insolée de la couche organométallique, une étape de réalisation d'un masque dur en regard d'une partie de la couche de semi-conducteur destinée à comporter les zones de source, drain et canal du transistor, une étape de retrait de parties de la couche de résine non recouvertes par le masque dur, puis une étape d'oxydation de parties de la couche de semi-conducteur non recouvertes par le masque dur.

Le procédé peut comporter en outre, entre l'étape d'oxydation des parties de la couche de semi-conducteur non recouvertes par le masque dur et l'étape c) de retrait de la partie insolée de la couche organométallique, une étape de retrait du masque dur, puis une étape de dépôt d'au moins un matériau de grille au moins à l'intérieur du contour formé par l'espaceur, pouvant ainsi former la grille du transistor.

Le procédé peut comporter en outre, entre l'étape de dépôt du matériau de grille et l'étape c) de retrait de la partie insolée de la couche organométallique, une étape de retrait de la partie restante de la couche de résine et des parties oxydées de la couche de semi-conducteur.

L'étape d) de réalisation des portions diélectriques peut être obtenue par la mise en oeuvre d'une étape de dépôt d'un premier matériau diélectrique au moins sur les parois des emplacements vides formés par le retrait de ladite partie insolée de la couche organométallique et une étape de dépôt d'un second matériau diélectrique, différent du premier matériau diélectrique, dans l'espace restant desdits emplacements vides.

Les premier et second matériaux diélectriques déposés pour former les portions diélectriques peuvent également être déposés autour de la grille, pouvant ainsi former des espaceurs.

L'empilement réalisé à l'étape a) peut comporter en outre une seconde couche diélectrique disposée entre le substrat et la couche organométallique.

Le procédé peut comporter en outre, après l'étape d) de réalisation des portions diélectriques, une étape de réalisation d'au moins un contact électrique à travers au moins la couche diélectrique et la grille du transistor, relié à la portion de matériau organométallique.

De manière générale, le procédé présenté ici permet également de réaliser des dissymétries au niveau des zones de source, de drain, ou de canal.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un transistor SOI à oxyde enterré mince et plan de masse selon l'art antérieur,
- les figures 2A à 2I représentent les étapes d'un procédé de réalisation d'un transistor SOI à oxyde enterrée d'épaisseur variable et plan de masse auto-aligné avec la grille, objet de la présente invention, selon un premier mode de réalisation,
- les figures 3A et 3B représentent des étapes d'un procédé de réalisation d'un transistor SOI à oxyde enterré d'épaisseur variable et plan de masse auto-aligné avec la grille, objet de la présente invention, selon un second mode de réalisation,
- les figures 4A à 4U représentent les étapes d'un procédé de réalisation d'un transistor SOI à oxyde enterrée d'épaisseur variable et plan de masse auto-aligné avec la grille, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles dans le cadre défini par les revendications ci-jointes.

### EXPOSÉ DÉTAILLÉ DE MODES DE RÉALISATION PARTICULIERS

On se réfère tout d'abord aux figures 2A à 2I qui représentent les étapes d'un procédé de réalisation d'un transistor 100 SOI à déplétion totale, à oxyde enterré d'épaisseur variable, et comportant une grille et un plan de masse auto-alignés, selon un premier mode de réalisation.

Comme représenté sur la figure 2A, on forme tout d'abord, contre une face d'un substrat 102 semi-conducteur, par exemple à base de silicium, une couche 104 photosensible et à base d'un matériau organométallique, c'est-à-dire un composé comportant au moins une liaison métal-carbone. Le métal de ce matériau organométallique peut notamment être choisi parmi les métaux suivants : Pt, Au, Pd, Ag. Un composé organométallique à base de platine peut par exemple être du (C₃F₇)₂PtC₉H₁₂. Le matériau organométallique peut également être à base d'oxyde métallique (par exemple : Al₂O₃, TiO₂, ZnO, MnO₂, ZrO₂ RuO₂, etc.), ou encore de BaTiO₃, de BST (titanate de strontium et de baryum), PZT (titanate-zirconate de plomb) ou encore d'ITO (oxyde d'indium et d'étain) ou tout type de matériau organométallique photosensible par exemple à des faisceaux d'électrons. Cette couche 104 peut être déposée sur le substrat 102 par pulvérisation cathodique, dépôt à la tournette, dépôt par projection à chaud, ou toute autre technique de dépôt adaptée au matériau organométallique de la couche 104. La couche organométallique 104 peut par exemple avoir une épaisseur égale à environ 135 nm. L'épaisseur de la couche organométallique 104 obtenue dépend de la technique de dépôt utilisée. On peut obtenir avec un dépôt à la tournette une couche organométallique 104 d'épaisseur égale ou supérieure à 135 nm. Un dépôt par pulvérisation permettra d'obtenir des épaisseurs inférieures à 135 nm. Cette épaisseur initiale peut dépendre également de transformations ou de changements de volume réalisés ultérieurement au dépôt de cette couche 104.

Une couche diélectrique 106, par exemple à base d'un oxyde tel que du SiO₂ et d'épaisseur égale à environ 10 nm ou comprise entre environ 1 nm et 10 nm est disposée sur la couche organométallique 104. Cette couche diélectrique 106 peut également être formée par du diélectrique High-K ou à constante diélectrique élevée (supérieure à 3,9), et/ou du diélectrique Low-K ou à constante diélectrique faible (inférieure à 3,9) et/ou du TEOS (tetraéthoxysilane). Une couche à base de semi-conducteur 108 est également disposée sur la couche d'oxyde 106 et comporte une épaisseur égale à environ 5 nm ou comprise entre environ 5 nm et 15 nm. La couche diélectrique 106 peut être déposée par collage, lithographie nanoimprint, ou toute autre technique de dépôt appropriée sur la couche organométallique 104. La couche 108 à base de semi-conducteur peut être déposée par CVD (dépôt chimique en phase vapeur), ALD (dépôt de couche atomique) ou toute autre technique de dépôt appropriée sur la couche diélectrique 106.

On réalise ensuite des tranchées d'isolation à travers les couches 104, 106, 108 et le substrat 102, délimitant une zone active du transistor 100 dans laquelle vont notamment être réalisés des zones de source, drain et canal, ainsi que la grille et le plan de masse auto-alignés. Ces tranchées sont ensuite remplies par un matériau diélectrique 110, par exemple à base de SiO₂ (figure 2B).

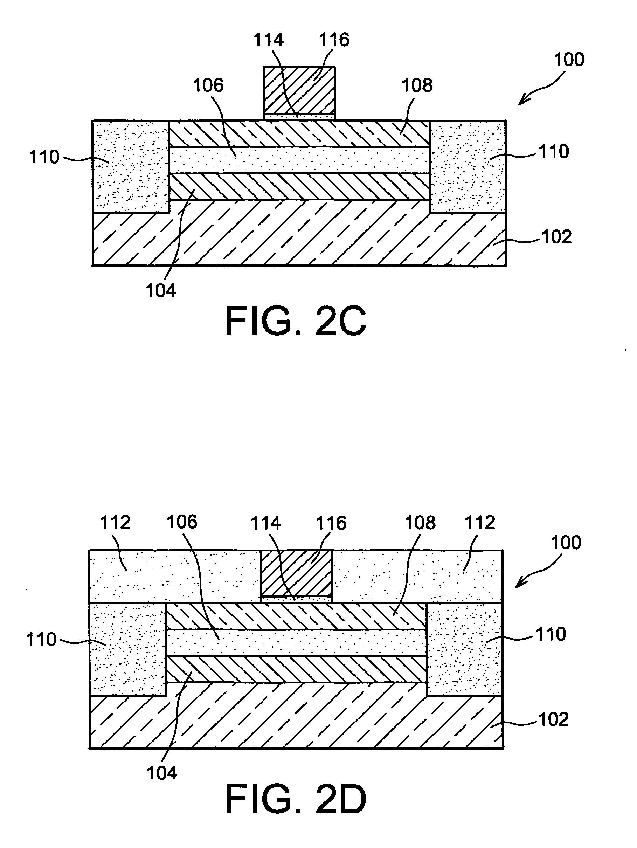

Comme représenté sur la figure 2C, on réalise une grille 116 et un oxyde de grille 114 sur la couche de silicium 108, par exemple en formant tout d'abord une couche d'oxyde, par exemple à base de SiO₂ et d'épaisseur égale à environ 1 nm, et une couche à base d'un matériau de grille, par exemple du polysilicium, sur la couche de silicium 108, et d'épaisseur par exemple égale à 100 nm ou comprise entre environ 50 nm et 150 nm. La grille 116 et l'oxyde de grille 114 sont ensuite réalisés par la mise en oeuvre d'étapes de photolithographie, de masquage et de gravure des couches d'oxyde et de polysilicium précédemment déposées.

Sur la figure 2D, une couche de résine photosensible 112, par exemple de la résine HSQ, est ensuite déposée sur l'ensemble du transistor 100, c'est-à-dire sur la couche de silicium 108 et les tranchées d'isolation 110, ainsi que sur la grille 116. Une étape de planarisation mécano-chimique ou de fluage mutuelle (en fonction de la viscosité de la résine HSQ) avec arrêt au niveau de la grille 116 est ensuite réalisée.

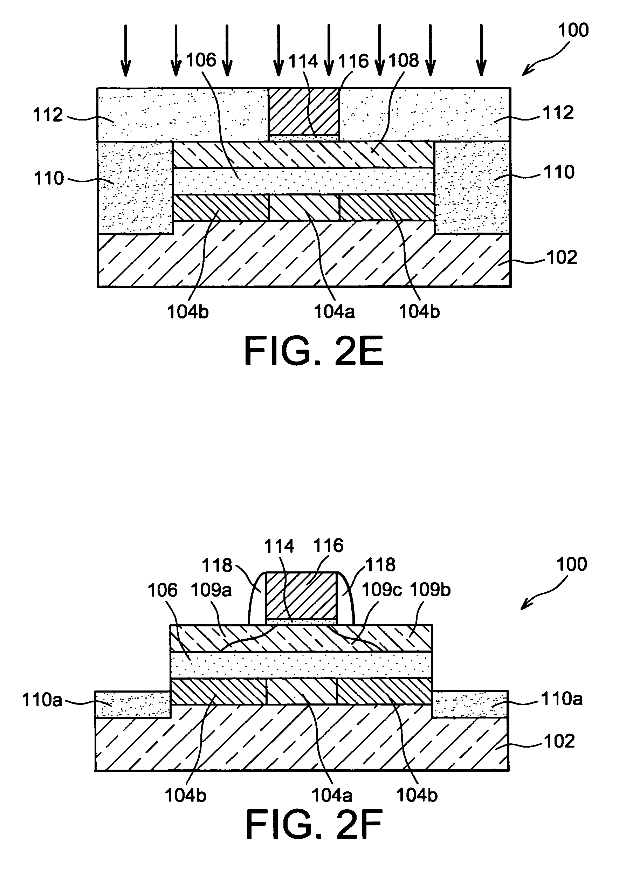

Comme représenté sur la figure 2E, on réalise ensuite une insolation pleine couche par faisceaux d'électrons, c'est-à-dire une insolation de l'ensemble du transistor 100. La résine HSQ insolée de la couche 112 est ensuite transformée, par un recuit, en diélectrique, formant ainsi un oxyde. Les portions 104b de la couche organométallique 104 ne se trouvant pas sous la grille 116 sont insolées par les faisceaux d'électrons, contrairement à la portion 104a de la couche organométallique 104 protégée par la grille 116 lors de cette étape d'insolation. Cette insolation forme donc, dans la couche organométallique 104, des portions 104b insolées pouvant par la suite être gravées sélectivement par rapport à la portion 104a protégée par la grille 116. Les faisceaux d'électrons utilisés peuvent avoir une énergie comprise entre environ 5 KeV et 100 KeV. L'énergie des faisceaux est choisie notamment en fonction des épaisseurs des couches que les faisceaux d'électrons doivent traverser.

Le matériau diélectrique 112 issu de la couche de résine HSQ est ensuite gravé. Des étapes d'implantation sont alors mises en oeuvre pour former des zones de source 109a et de drain 109b dans la couche de silicium 108. Un canal 109c est également formé dans la couche de silicium 108, sous la grille 116. Des espaceurs 118 sont également réalisés autour de la grille 116 et de l'oxyde de grille 114. Une partie des tranchées d'isolation 110 est alors retirée, laissant subsister des portions d'isolation 110a au niveau du substrat 102 et de portions insolées 104b de la couche organométallique 104 (figure 2F).

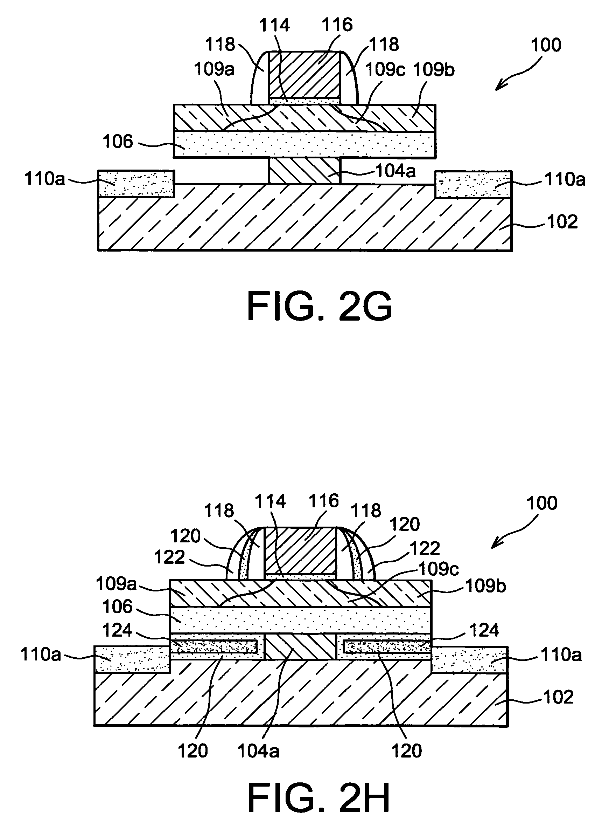

En gravant en partie les tranchées d'isolation 110, on forme un accès à la couche organométallique 104. On peut ainsi graver les portions insolées 104b de la couche 104, et laisser subsister uniquement la portion 104a se trouvant sous la grille 116 (figure 2G). Grâce à l'insolation précédemment réalisée dans la couche 104 avec la grille 116 comme masque, la portion restante 104a non insolée forme un plan de masse du transistor 100 auto-aligné avec la grille 116. Ainsi, la forme et les dimensions d'une section, dans un plan sensiblement parallèle à la face du substrat 102 sur laquelle est disposée la portion 104a, de la grille 116 sont sensiblement égales à la forme et aux dimensions d'une section de la portion organométallique 104a dans ce même plan.

Comme représenté sur la figure 2H, une couche à base de diélectrique 120, par exemple du SiO₂ est déposée sur les espaceurs 118 ainsi que sur les parois des creux formés par le précédent retrait des portions insolées 104b. Une couche de nitrure, par exemple à base de nitrure de silicium, est ensuite déposée sur la couche diélectrique 120, formant des seconds espaceurs 122 et des portions 124 remplissant les creux formés lors du retrait des portions insolées 104b. Les dépôts peuvent être réalisés par PECVD (dépôt chimique en phase vapeur assisté par plasma), LPCVD (dépôt chimique en phase vapeur basse pression) ou encore ALD. D'autres types de matériaux (conducteurs, semi-conducteurs, par exemple du polysilicium, du polysilicium-germanium) peuvent également être déposés dans les creux formés. Il est possible de réaliser ainsi différentes fonctions selon les matériaux déposés dans les creux réalisés. Les couches de nitrure 122 et d'oxyde 120 peuvent par exemple avoir des épaisseurs comprises entre environ 10 nm et 30 nm. Ces épaisseurs peuvent notamment être fonction des performances souhaitées du transistor.

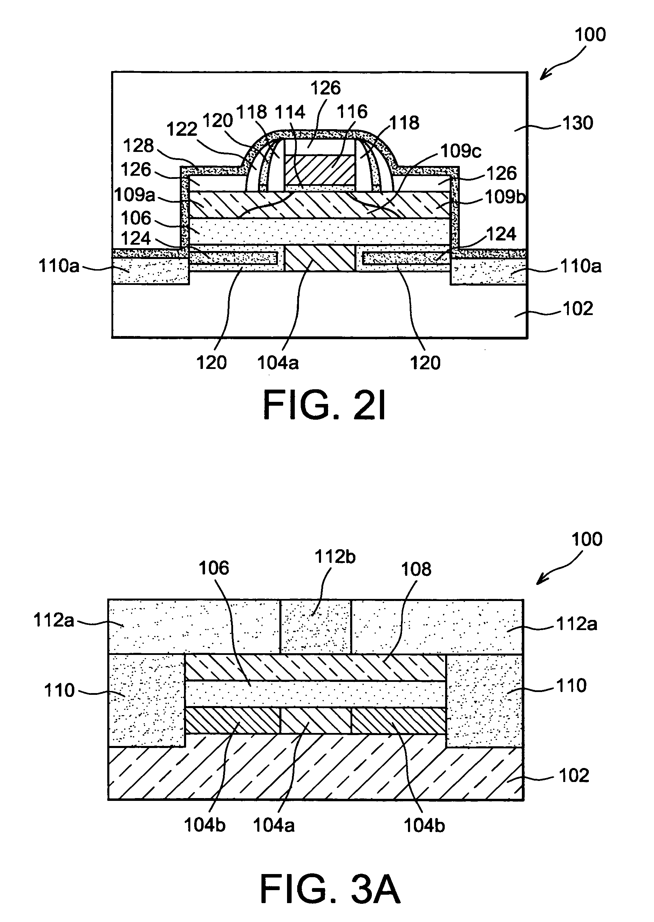

Comme représenté sur la figure 2I, on réalise enfin une siliciuration de la grille 116, de la source 109a et du drain 109b précédemment réalisés dans la couche de silicium 108, formant des portions de siliciure 126. Une couche de nitrure 128 et une couche de diélectrique pré-métal (PMD) 130 sont alors déposées sur le transistor 100 pour réaliser son isolation électrique. La couche de nitrure 128 est par exemple à base de SiN, la couche PMD 130 étant à base de SiO₂. Les épaisseurs de ces couches 128 et 130 peuvent être comprises entre environ 150 nm et 250 nm.

On obtient ainsi un transistor SOI 100 à déplétion totale (FD-SOI) lorsque la couche de silicium 108 a une épaisseur inférieure ou égale à environ 30 nm. La portion 104a de matériau organométallique forme un plan de masse du transistor 100 s'étendant uniquement sous la grille 116. De plus, le transistor 100 ainsi réalisé comporte un oxyde enterré formé par la couche de SiO₂ 106 ainsi que par la couche diélectrique 120 et les portions de nitrure 124 déposées dans les creux formés par le retrait des portions insolées 104b de la couche organométallique 104. Cet oxyde enterré a donc une épaisseur variable : cette épaisseur est par exemple égale à environ 145 nm au niveau des source 109a et drain 109b, et égale à environ 10 nm au niveau de la grille 116. Cet oxyde enterré est également formé par des portions de matériaux de constantes diélectriques différentes.

En terme d'effet de canal court (sur le DIBL), ce transistor permet de gagner un facteur 2 par rapport aux transistors connus. De plus, ce transistor permet une réduction des capacités de jonctions d'environ 20% par rapport à un transistor à oxyde enterré mince sans ground plane (plan de masse).

Dans ce premier mode de réalisation, le plan de masse 104a n'est pas connecté. Toutefois, dans une variante de réalisation, il est possible de former une connexion électrique du plan de masse 104a à travers le PMD 130, la grille 116, la couche semi-conductrice 108 et la couche diélectrique 106.

Un procédé de réalisation du transistor 100 SOI à déplétion totale, plan de masse et grille auto-alignés et oxyde enterré d'épaisseur variable selon un second mode de réalisation va maintenant être décrit.

Les étapes précédemment décrites en liaison avec les figures 2A et 2B sont tout d'abord mises en oeuvre.

Comme représenté sur la figure 3A, on réalise ensuite le dépôt de la couche de résine 112 sur la couche de silicium 108 et sur les tranchées d'isolation 110. On réalise ensuite une insolation par faisceau d'électrons du dispositif 100, excepté au niveau de la future grille du transistor 100. On forme ainsi dans la couche de résine HSQ 112 des portions insolées 112a et une portion 112b non insolée. La résine HSQ, au niveau des portions insolées 112b, est ensuite transformée par recuit en matériau diélectrique. Les faisceaux d'électrons réalisent également l'insolation des portions 104b de la couche organométallique 104 ne se trouvant pas au niveau de la grille du transistor 100. La portion 104a de la couche organométallique 104 se trouvant sous la grille 116 est protégée lors de cette insolation.

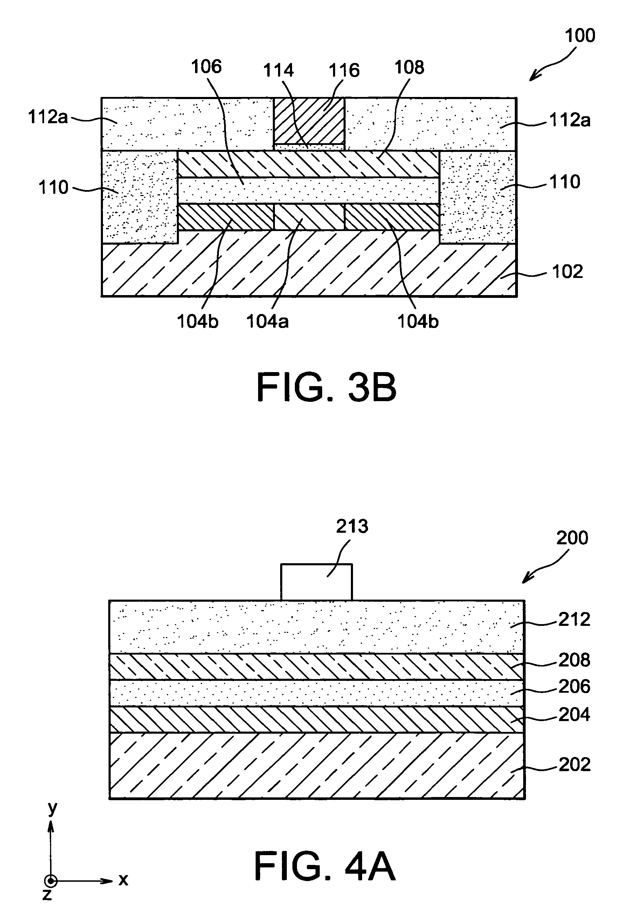

La portion 112b non insolée de la couche de résine HSQ 112 est ensuite retirée. Comme représenté sur la figure 3B, l'oxyde de grille 114 et la grille 116 sont alors réalisés dans l'emplacement libéré par le retrait de la portion 112b de résine, par un procédé damascène (dépôt du matériau de grille dans l'emplacement libéré, le matériau de grille débordant sur les portions diélectriques 112a, puis planarisation mécano-chimique du matériau de grille avec arrêt sur la résine insolée 112a).

Le procédé est ensuite achevé en mettant en oeuvre les étapes précédemment décrites en liaison avec les figures 2F à 2I.

Par rapport au premier mode de réalisation, le procédé selon le second mode de réalisation permet « d'économiser » les étapes de photolithographie et de gravure mises en oeuvre pour la réalisation de la grille dans le premier mode de réalisation. Ce second mode de réalisation offre notamment une grande flexibilité sur le choix du type de résine pouvant être utilisé (résine positive ou négative).

De manière générale, selon la polarité de la résine utilisée, il est donc possible de réaliser un transfert direct du plan de masse (Ground Plane) du transistor sous la grille, ou de modifier les zones de source et de drain du transistor.

On se réfère maintenant aux figures 4A à 4U représentant les étapes d'un procédé de réalisation d'un transistor SOI 200 à déplétion totale, plan de masse et grille auto-alignés et oxyde enterré d'épaisseur variable selon un troisième mode de réalisation.

Comme pour le premier mode de réalisation, on forme tout d'abord, sur un substrat 202 par exemple à base de silicium, une couche 204 photosensible et à base d'un matériau organométallique, par exemple similaire à la couche 104, par pulvérisation cathodique, dépôt à la tournette, dépôt par projection à chaud, ou toute autre technique de dépôt adaptée en fonction du matériau organométallique de la couche 204 (figure 4A).

Une couche de diélectrique 206, par exemple similaire à la couche diélectrique 106, est disposée sur la couche organométallique 204. Une couche à base de semi-conducteur 208, pouvant également être similaire à la couche 108 précédemment décrite, est disposée sur la couche d'oxyde 206.

Une couche de résine HSQ 212 est disposée sur la couche à base de semi-conducteur 208. Un masque de gravure 213 dont le motif peut correspondre à la future grille du transistor 200, est formé sur la couche de résine 212. Le motif du masque de gravure 213 peut toutefois être différent notamment dans le cas de dispositifs asymétriques.

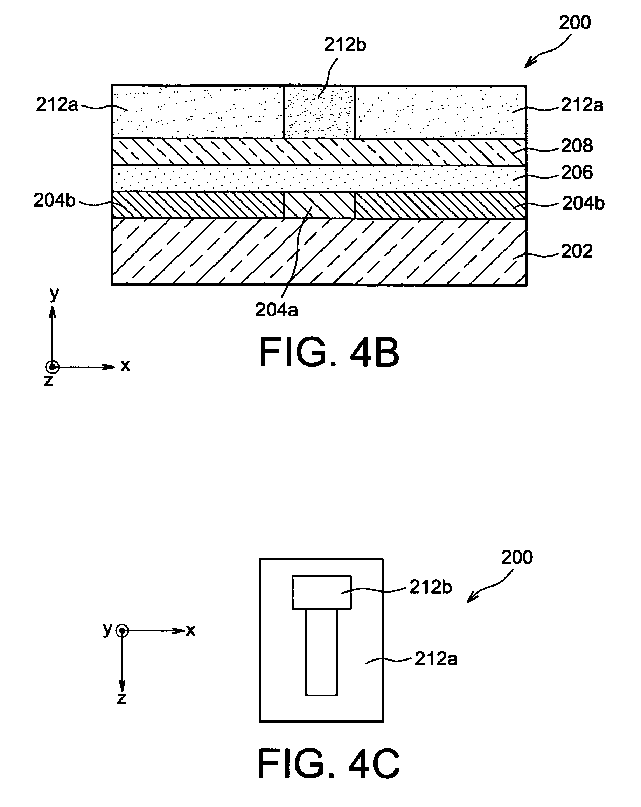

On réalise une insolation par faisceau d'électrons du dispositif 200, formant dans la couche de résine 212 des zones insolées 212a et une zone non insolée 212b correspondant au motif de la future grille du transistor 200. Cette étape forme également dans la couche organométallique 204 des portions insolées 204b et une portion non insolée 204a dont le motif correspond à celui du masque 213. Le masque 213 est ensuite retiré du dispositif 200 (figures 4B et 4C).

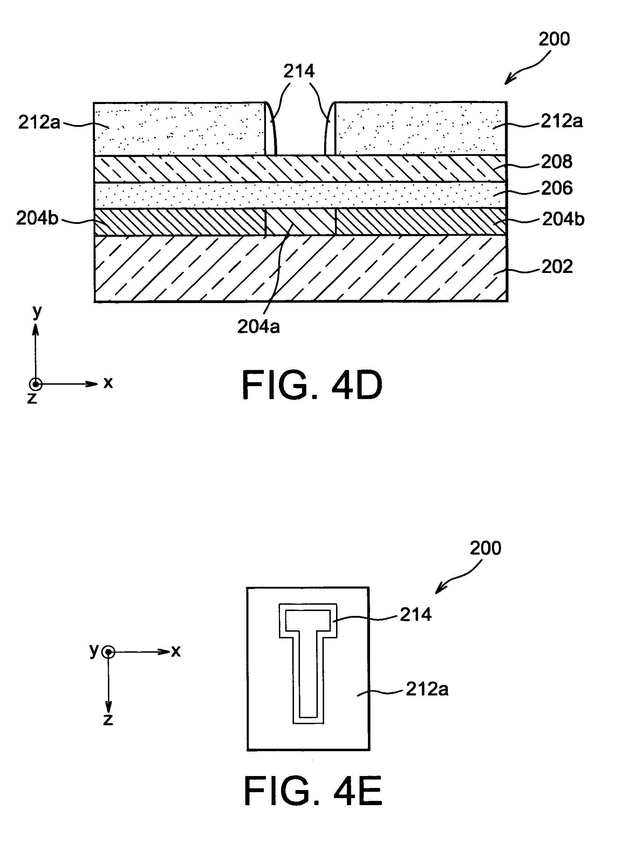

Comme représenté sur les figures 4D et 4E, la portion non insolée 212b de résine est supprimée, par exemple par développement. Un espaceur 214 est ensuite déposé, par exemple par PECVD, sur les parois latérales des portions diélectriques 212a de résine insolées, dans le creux formé par le retrait de la portion de résine 212b.

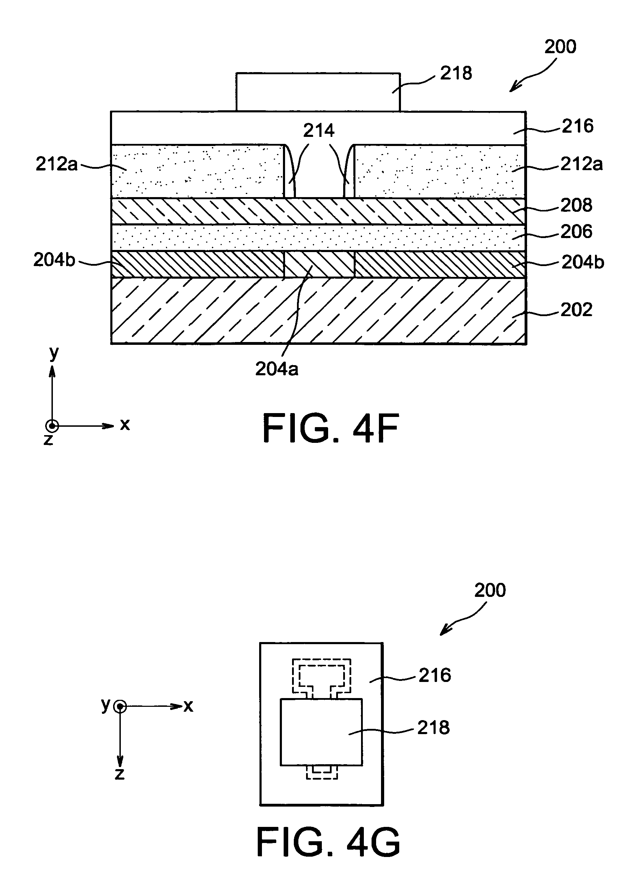

Un matériau 216 destiné à former un masque dur, par exemple du TEOS (tétraéthylorthosilicate), est déposé sur l'ensemble du dispositif 200, c'est-à-dire à la fois dans le creux formé par le retrait de la portion de résine 212b et sur les portions diélectriques restantes 212a (figures 4F et 4G). Un masque de gravure 218 est également formé sur le matériau 216 de masque dur. Le motif de ce masque de gravure 218 correspond aux futurs emplacements des zones de source, de drain et de canal, ainsi qu'à une partie de la grille du transistor 200.

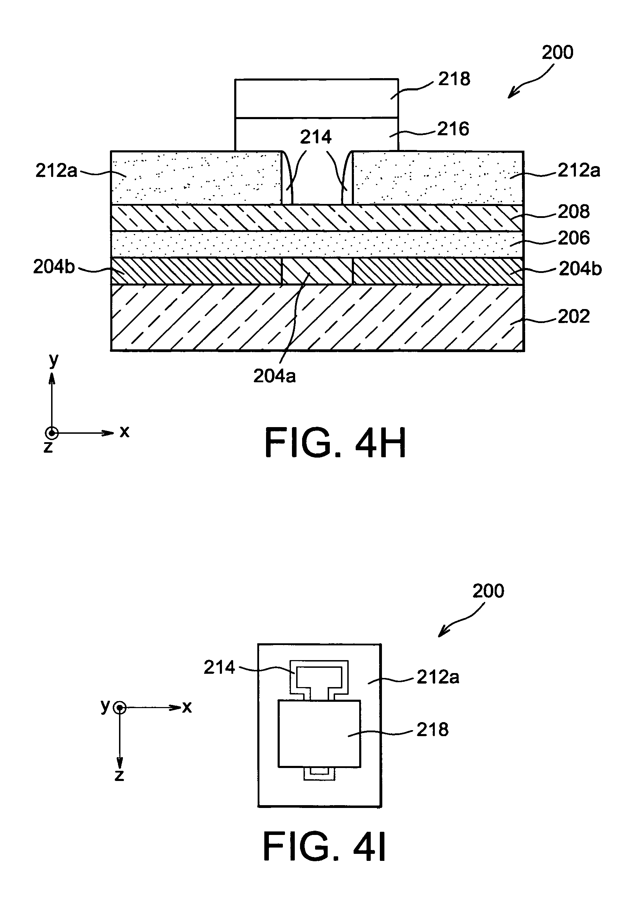

Le matériau 216 est ensuite gravé selon le motif du masque 218 (figures 4H et 4I). Ainsi, seule la portion de matériau 216 se trouvant sous le masque de gravure 218 est conservée et forme un masque dur 216.

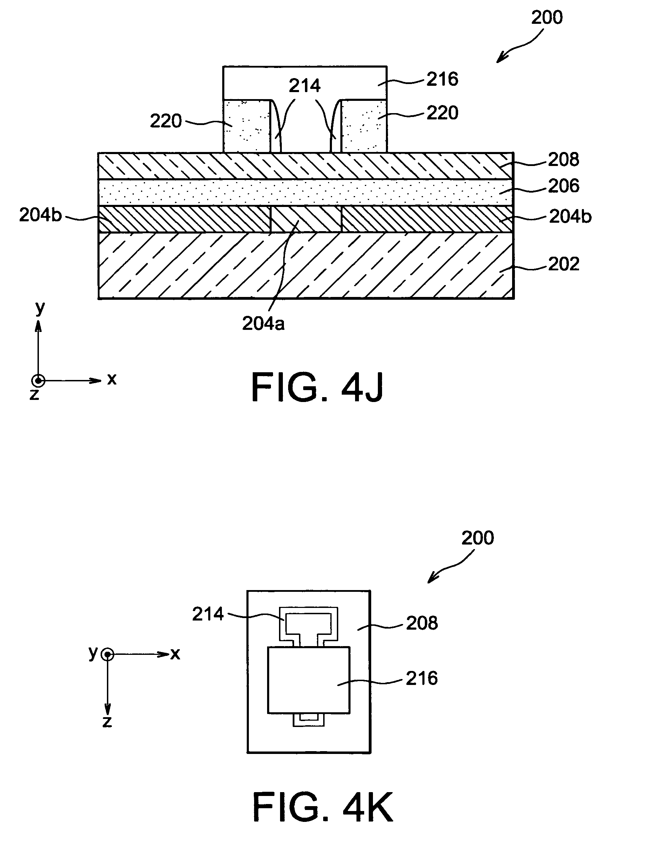

Les portions diélectriques 212a issues de la couche de résine 212 sont ensuite gravées selon le motif formé par le masque dur 216, des portions restantes 220 de diélectrique étant conformes au motif du masque dur 216 (figures 4J et 4K).

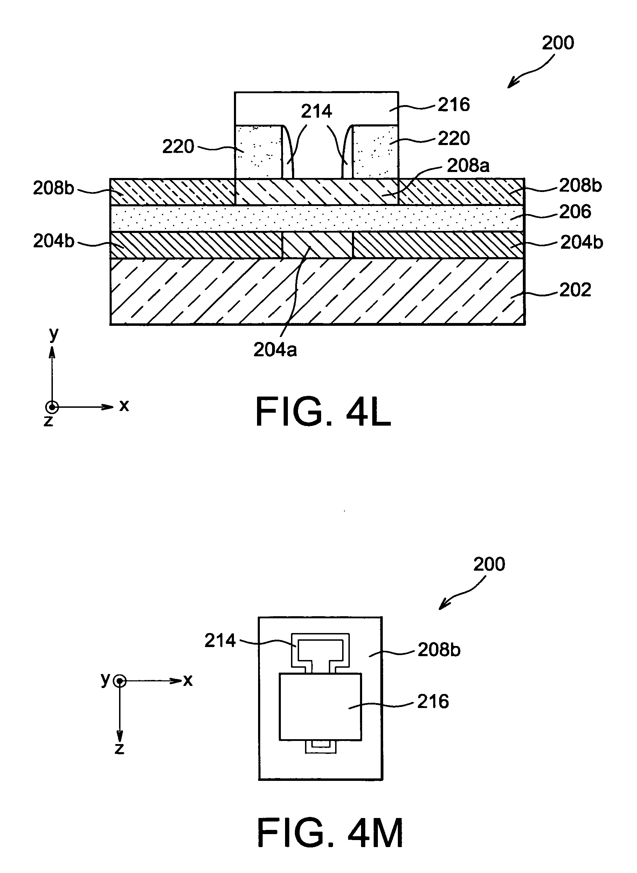

On réalise ensuite une oxydation des portions de la couche de silicium 208 non recouvertes par le masque dur 216. On forme ainsi des portions diélectriques de SiO₂ 208b. Une portion de silicium 208a est conservée sous le masque dur 216 (Figures 4L et 4M).

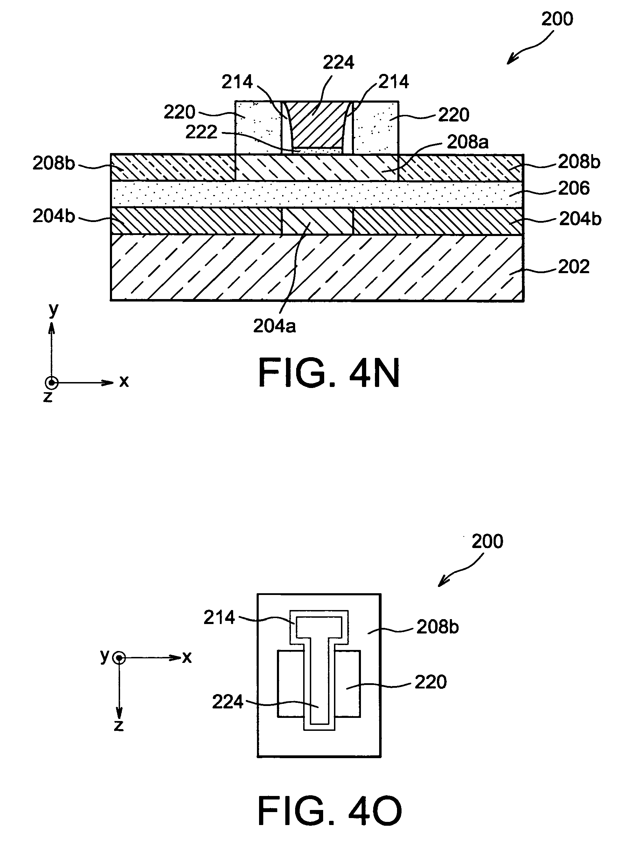

Comme représenté sur les figures 4N et 4O, le masque de gravure 216 est alors supprimé, puis un diélectrique de grille 222 et une grille 224 sont ensuite réalisés par dépôt et gravure dans le creux précédemment formé par la suppression de la portion de résine 212b. La grille 224 peut être réalisée par un procédé damascène, comme dans le second mode de réalisation précédemment décrit.

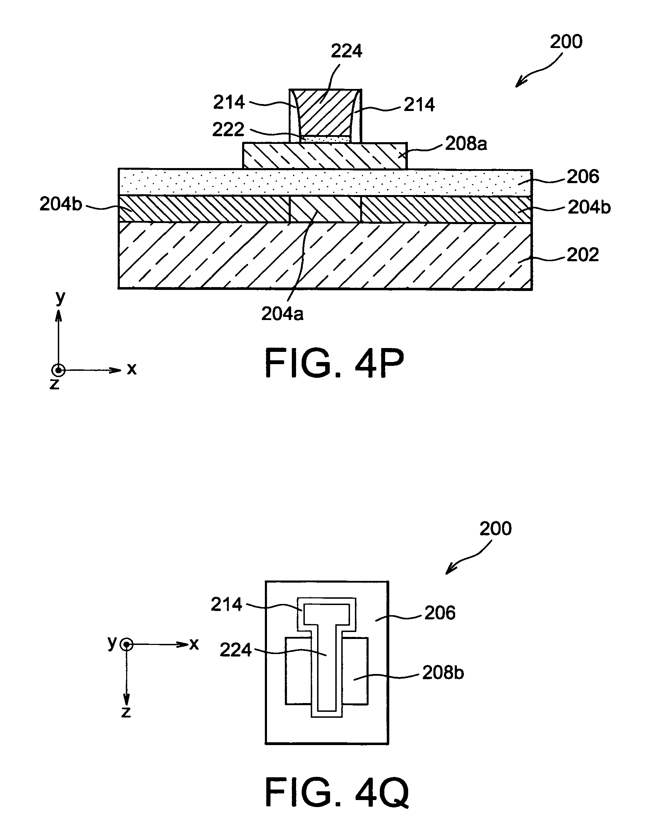

On supprime ensuite les portions diélectriques 220 et 208b par exemple par gravure (figures 4P et 4Q).

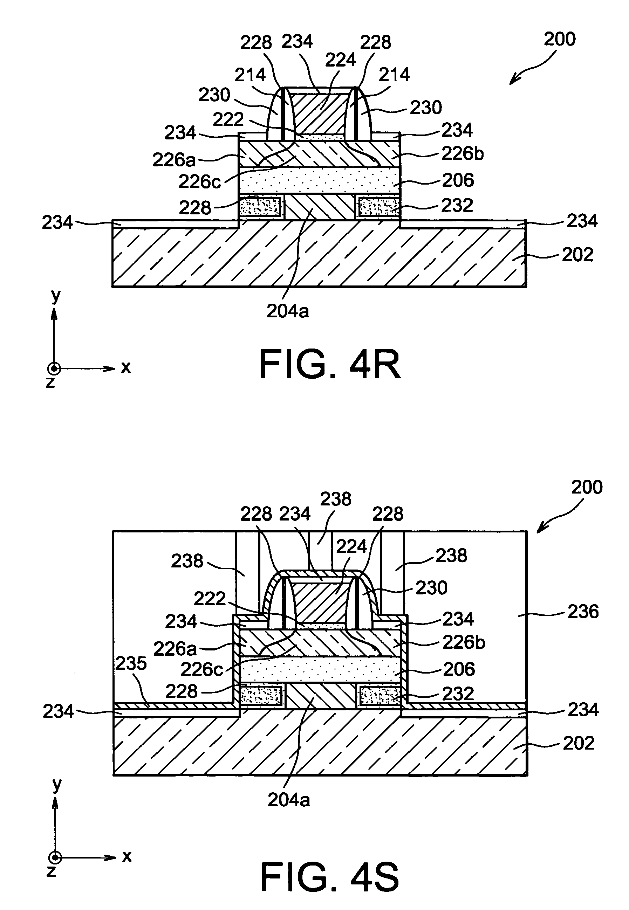

On réalise ensuite, comme pour les précédents modes de réalisation, des étapes d'implantation pour former des zones de source 226a et de drain 226b dans la couche de silicium 208. Un canal 226c est également formé dans la couche de silicium 208, sous la grille 224. On grave également une partie de la couche d'oxyde 206, formant un accès à la couche organométallique 204. On grave alors les portions insolées 204b en laissant subsister uniquement la portion 204a se trouvant sous la grille 224 formant un plan de masse du transistor 200 auto-aligné avec la grille 224. Une couche à base de diélectrique 228 est déposée sur les espaceurs 214 ainsi que sur les parois des creux formés par le précédent retrait des portions insolées 204b. Une couche de nitrure, par exemple à base de nitrure de silicium, est ensuite déposée sur la couche diélectrique 228, formant des seconds espaceurs 230 et des portions 232, remplissant les creux formés lors du retrait des portions insolées 204b. On réalise enfin une siliciuration de la grille 224, de la source et du drain et du substrat 202, formant des portions de siliciure 234 (Figure 4R).

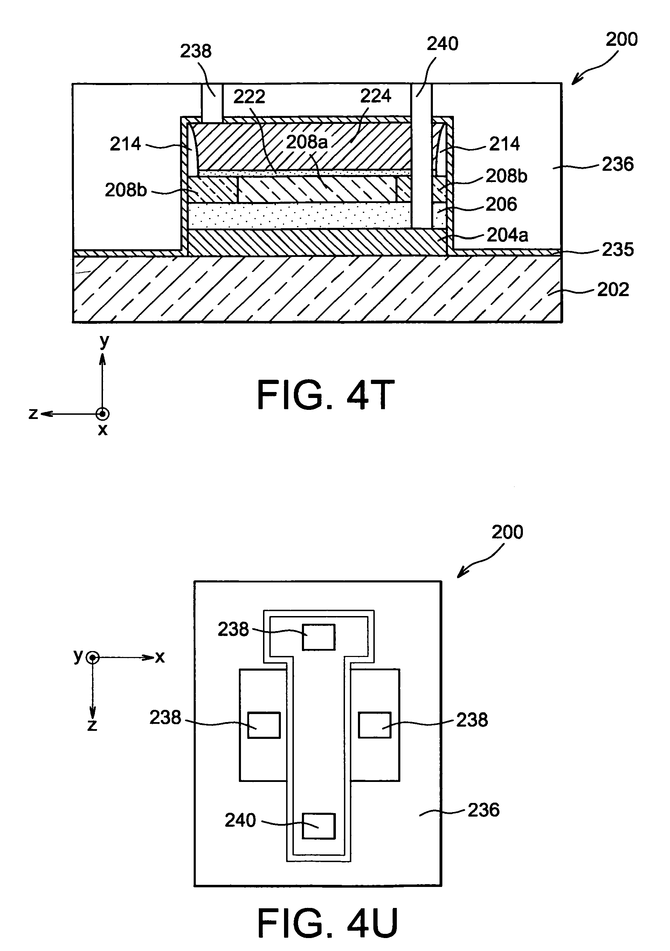

Une couche de nitrure 235 et une couche de diélectrique pré-métal (PMD) 236 sont alors déposées sur le transistor 200 pour réaliser son isolation électrique. Des contacts métalliques 238 sont ensuite réalisés pour contacter la grille 224, la source 226a et le drain 226b. Un contact 240 relié au plan de masse 204a est également réalisé (figures 4S, 4T et 4U).

On obtient ainsi un transistor 200 à déplétion totale sur SOI (FD-SOI). Grâce au débordement du plan de masse formé par la portion 204a à base de matériau organométallique sous la grille 224, on peut réaliser le contact 240 sans étapes de photolithographie supplémentaires. De plus, le transistor 200 ainsi réalisé comporte un oxyde enterré formé par la couche de SiO₂ 206 ainsi que par la couche diélectrique 228 et les portions de nitrure 232 déposées dans les creux formés par le retrait des portions insolées 204b de la couche organométallique 204. Comme dans les modes de réalisation précédents, cet oxyde enterré a une épaisseur variable, par exemple similaire à celle décrite en liaison avec le premier mode de réalisation.

Dans une variante des précédents modes de réalisation décrits, le procédé peut être mis en oeuvre à partir d'un substrat double SOI, c'est-à-dire comportant entre le substrat et la couche organométallique, une couche intermédiaire diélectrique, par exemple à base d'oxyde tel que de l'oxyde de silicium. Cette variante peut être particulièrement intéressante si l'on souhaite ne pas former de siliciure directement sur le substrat.

## Revendications

1. procédé de réalisation d'un transistor (100, 200) à grille (116, 224) et plan de masse (104a, 204a) auto-alignés, comportant au moins les étapes de :
a) réalisation d'un empilement, sur une face d'un substrat (102, 202) à base d'au moins un seri-conducteur, comprenant au moins une couche (104, 204) à base d'au moins un matériau organométallique est une couche (106, 206) à base d'au moins un matériau diélectrique disposée sur la couche organométallique (104, 204) et destinée à former une couche isolante enterrée du transistor (100, 200),
b) insolation par faisceaux d'électrons d'au moins une partie (104b, 204b) de la couche organométallique (104, 204), une portion (104a, 204a) de la couche organométallique (104, 204) distincte de la partie (104b, 204b) insolée de la couche organométallique (104, 204) et destinée à former le plan de masse du transistor (100, 200) étant protégée des faisceaux d'électrons par un masque (116, 213) durant cette étape d'insolation, la forme et les dimensions d'une section, dans un plan sensiblement parallèle à la face du substrat (102, 202), de la grille (116, 224) du transistor (100, 200) étant destinées à être sensiblement égales à la forme est aux dimensions d'une section de ladite portion (104a, 204a) de matériau organométallique dans ledit plan,
c) retrait de la partie insolée (104b, 204b) de la couche organométallique (104, 204),
d) réalisation de portions diélectriques (120, 124, 228, 232) dans des emplacements vides formés par le retrait de ladite partie insolée (104b, 204b) de la couche organométallique (104, 204), entre la face du substrat (102, 202) et la couche diélectrique (106, 206), auteur de ladite portion (104a, 204a de la couche organométallique (104, 204).

2. Procédé selon la revendication 1, l'empilement réalisé à l'étape a) comportant en outre une couche (108, 208) à base d'au moins un semi-conducteur telle que la couche diélectrique (106, 206) soit disposée entre ladite couche de semi-conducteur (108, 208) et la couche organométallique (104, 204).

3. Procédé selon la revendication 2, comportant en outre, entre l'étape a) de réalisation de l'empilement et l'étape b) d'insolation, une étape de réalisation de la grille (116) du transistor (100) sur la couche de semi-conducteur (108), la grille (116) formant le masque protégeant la portion (104a) de la couche organométallique (104) durant l'étape b) d'insolation.

4. Procédé selon la revendication 3, comportant en outre, entre l'étape de réalisation de la grille (116) du transistor (100) et l'étape b) d' insolation, une étape de dépôt d'une couche (112) de résine photosensible au moins sur la grille (116) es sur la couche de semi-conducteur (108) et une étape de planarisation mécano-chimique de la couche de résine (112) avec arrêt sur la grille (116).

5. Procédé selon la revendication 2, comportant en outre, entre l'étape a) de réalisation de l'empilement et l'étape b) d'insolation, une étape de dépôt d'une couche de résine photosensible (112) au moins sur la couche de semi-conducteur (108) de l'empilement, l'étape b) réalisant également l'insolation d'une partie (112a) de la couche de résine photosensible (112).

6. Procédé selon la revendication 5, comportant en outre, entre l'étape b) d'insolation et l'étape c) de retrait de la partie insolée (104b) de la couche organométallique (104), une étape de retrait de la partie insolée (112a) de la couche de résine photosensible (112) formant ainsi, dans la couche de résine (112), un creux, puis la réalisation de la grille (116) par au moins une étape de dépôt d'au moins un matériau de grille dans ledit creux et sur la couche de résine (112) et une étape de planarisation mécano-chimique avec arrêt sur la couche de résine (112).

7. Procédé selon l'une des revendications 4 ou 6, comportant en outre, entre l'étape de planarisation mécano-chimique et l'étape c) de retrait de la partie insolée (104b) de la couche organométallique (104), une étape de retrait de la partie insolée (112a) de la couche de résine (112).

8. Procédé selon la revendication 2, l'empilement réalisé à l'étape a) comportant en outre une couche de résine photosensible (212) telle que la couche de semi-conducteur (208) soit disposée entre ladite couche de résine (212) et la couche diélectrique (206).

9. Procédé selon la revendication 8, comportant en outre, entre l'étape a) de réalisation de l'empilement et l'étape b) d'insolation, une étape de réalisation du masque (213) destiné à protéger la portion (204a) de la couche organométallique (204) durant l'étape b) d'insolation, sur la couche de résine photosensible (212).

10. Procédé selon la revendication 9, l'étape b) d'insolation réalisant également l'insolation d'une partie (212a) de la couche de résine photosensible (212), une portion (212b) de la couche de résine photosensible (212), distincte de ladite partie (212a) de la couche de résine photosensible (212), étant protégée des faisceaux d'électrons par le masque (213) durant cette étape d'insolation, la forme et les dimensions d'une section, dans un plan sensiblement parallèle à la face du substrat (202), de la grille (224) du transistor (200) étant sensiblement égales à la forme et aux dimensions d'une section de ladite portion (212b) de la couche de résine photosensible (212) dans ledit plan.

11. Procédé selon la revendication 10, comportant en outre, entre l'étape b) d'insolation et l'étape c) de retrait de la partie insolée (204b) de la couche organométallique (204), une étape de retrait de la partie non insolée (212b) de la couche de résine photosensible (212).

12. Procédé selon la revendication 11, comportant en outre, entre l'étape de retrait de la partie non insolée (212b) de la couche de résine photosensible (212) et l'étape c) de retrait de la partie insolée (204b) de la couche organométallique (204), une étape de réalisation d'au moins un espaceur (214) contre des parois latérales d'un creux formé dans la couche de résine (212) par le retrait de la partie non insolée (212b) de la couche de résine (212), cet espaceur (214) étant destiné à former un contour de la grille (224) du transistor (200).

13. Procédé selon la revendication 12, comportant en outre, entre l'étape de réalisation de l'espaceur (214) dans le creux formé dans la couche de résine (212) et l'étape c) de retrait de la partie insolée (204b) de la couche organométallique (204), une étape de réalisation d'un masque dur (216) en regard d'une partie de la couche de semi-conducteur (208) destinée à comporter les zones de source (226a), drain (226b) et canal (226c) du transistor (200), une étape de retrait de parties de la couche de résine (212) non recouvertes par le masque dur (216), puis une étape d'oxydation de parties (208b) de la couche de semi-conducteur (208) non recouvertes par le masque dur (216).

14. Procédé selon la revendication 13, comportant en outre, entre l'étape d'oxydation des parties (208b) de la couche de semi-conducteur (208) non recouvertes par le masque dur (216) et l'étape c) de retrait de la partie insolée (204b) de la couche organométallique (204), une étape de retrait du masque dur (216), puis une étape de dépôt d'au moins un matériau de grille (224) au moins à l'intérieur du contour formé par l'espaceur (214), formant ainsi la grille (224) du transistor (200).

15. Procédé selon la revendication 14, comportant en outre, entre l'étape de dépôt du matériau de grille (224) et l'étape c) de retrait de la partie insolée (204b) de la couche organométallique (204), une étape de retrait d'une partie restante (220) de la couche de résine (212) et des parties oxydées (208b) de la couche de semi-conducteur (208).

16. Procédé selon l'une des revendications 3 à 15, l'étape d) de réalisation des portions diélectriques étant obtenue par la mise en oeuvre d'une étape de dépôt d'un premier matériau diélectrique (228) au moins sur les parois des emplacements vides formés par le retrait de ladite partie insolée (204b) de la couche organométallique (204) et une étape de dépôt d'un second matériau diélectrique (232), différent du premier matériau diélectrique (228), dans l'espace restant desdits emplacements vides.

17. Procédé selon la revendication 16, les premier et second matériaux diélectriques (228, 232) déposés pour former les portions diélectriques étant également déposés autour de la grille (224), formant ainsi des espaceurs (228, 230).

18. Procédé selon l'une des revendications précédentes, l'empilement réalisé à l'étape a) comportant en outre une seconde couche diélectrique disposée entre le substrat (102, 202) et la couche organométallique (104, 204).

19. Procédé selon l'une des revendications précédentes, comportant en outre, après l'étape d) de réalisation des portions diélectriques (120, 124, 228, 232), une étape de réalisation d'au moins un contact électrique (240) à travers au moins la couche diélectrique (106, 206) et la grille (116, 224) du transistor (100, 200), relié à la portion de matériau organométallique (104a, 204a).

## Claims

1. Method for making a transistor (100, 200) with self-aligned gate (116, 224) and ground plane (104a, 204a), comprising at least the steps of:
a) forming a stack, on one face of a substrate (102, 202) based on at least one semi-conductor, comprising at least one layer (104, 204) based on at least one organometallic material and a layer (106, 206) based on at least one dielectric material arranged on the organometallic layer (104, 204) and intended to form a buried dielectric layer of the transistor (100, 200),
b) exposing by electron beams at least one part (104b, 204b) of the organometallic layer (104, 204), a portion (104a, 204a) of the organometallic layer (104, 204) different to the exposed part (104b, 204b) of the organometallic layer (104, 204) and intended to form the ground plane of the transistor (100, 200) being protected from the electron beams by a mask (116, 213) during this exposure step, the shape and the dimensions of a section, in a plane substantially parallel to the face of the substrate (102, 202), of the gate (116, 224) of the transistor (100, 200) being intended to be substantially equal to the shape and to the dimensions of a section of said portion (104a, 204a) of organometallic material in said plane,
c) removing the exposed part (104b, 204b) of the organometallic layer (104, 204),
d) forming dielectric portions (120, 124, 228, 232) in empty spaces formed by the removal of said exposed part (104b, 204b) of the organometallic layer (104, 204), between the face of the substrate (102, 202) and the dielectric layer (106, 206), around said portion (104a, 204a) of the organometallic layer (104, 204).

2. Method according to claim 1, the stack formed in step a) further comprising a layer (108, 208) based on at least one semi-conductor such that the dielectric layer (106, 206) is arranged between said semi-conductor layer (108, 208) and the organometallic layer (104, 204).

3. Method according to claim 2, further comprising, between step a) of forming the stack and step b) of exposure, a step of forming the gate (116) of the transistor (100) on the semi-conductor layer (108), the gate (116) forming the mask protecting the portion (104a) of the organometallic layer (104) during step b) of exposure.

4. Method according to claim 3, further comprising, between the step of forming the gate (116) of the transistor (100) and step b) of exposure, a step of depositing a photosensitive resin layer (112) at least on the gate (116) and on the semi-conductor layer (108) and a step of mechanical-chemical planarisation of the resin layer (112) while stopping on the gate (116).

5. Method according to claim 2, further comprising, between step a) of forming the stack and step b) of exposure, a step of depositing a photosensitive resin layer (112) at least on the semi-conductor layer (108) of the stack, step b) also including the exposure of one part (112a) of the photosensitive resin layer (112).

6. Method according to claim 5, further comprising, between step b) of exposure and step c) of removing the exposed part (104b) of the organometallic layer (104), a step of removing the exposed part (112a) of the photosensitive resin layer (112) thus forming, in the resin layer (112), a hollow, then forming the gate (116) by at least one step of depositing at least one gate material in said hollow and on the resin layer (112) and a step of mechanical-chemical planarisation while stopping on the resin layer (112).

7. Method according to one of claims 4 or 6, further comprising, between the step of mechanical-chemical planarisation and step c) of removing the exposed part (104b) of the organometallic layer (104), a step of removing the exposed part (112a) of the resin layer (112).

8. Method according to claim 2, the stack formed in step a) further comprising a photosensitive resin layer (212) such that the semi-conductor layer (208) is arranged between said resin layer (212) and the dielectric layer (206).

9. Method according to claim 8, further comprising, between step a) of forming the stack and step b) of exposure, a step of forming the mask (213) intended to protect the portion (204a) of the organometallic layer (204) during step b) of exposure, on the photosensitive resin layer (212).

10. Method according to claim 9, step b) of exposure also including the exposure of one part (212a) of the photosensitive resin layer (212), a portion (212b) of the photosensitive resin layer (212), different to said part (212a) of the photosensitive resin layer (212), being protested from the electron beams by the mask (213) during this exposure step, the shape and the dimensions of a section, in a plane substantially parallel to the face of the substrate (202), of the gate (224) of the transistor (200) being substantially equal to the shape and to the dimensions of a section of said portion (212b) of the photosensitive resin layer (212) in said plane.

11. Method according to claim 10, further comprising, between step b) of exposure and step c) of removing the exposed part (204b) of the organometallic layer (204), a step of removing the non exposed part (212b) of the photosensitive resin layer (212).

12. Method according to claim 11, further comprising, between the step of removing the non exposed part (212b) of the photosensitive resin layer (212) and step c) of removing the exposed part (204b) of the organometallic layer (204), a step or forming at least one spacer (214) against the lateral walls of a hollow formed in the resin layer (212) by the removal of the non exposed part (212b) of the resin layer (212), this spacer (214) being intended to form a contour of the gate (224) of the transistor (200).

13. Method according to claim 12, further comprising, between the step of forming the spacer (214) in the follow formed in the resin layer (212) and step c) of removing the exposed part (204b) of the organometallic layer (204), a step of forming a hard mask (216) opposite a part of the semi-conductor layer (208) intended to comprise the source (226a), drain (226b) and channel (226c) zones of the transistor (200), a step of removing parts of the resin layer (212) not covered by the hard mask (216), then a step of oxidising parts (208b) of the semi-conductor layer (208) not covered by the hard mask (216).

14. Method according to claim 13, further comprising, between the step of oxidising parts (208b) of the semi-conductor layer (208) not covered by the hard mask (216) and step c) of removing the exposed part (204b) of the organometallic layer (204), a step of removing the hard mask (216), then a step of depositing at least one gate material (224) at least inside the contour formed by the spacer (214), thus forming the gate (224) of the transistor (200).

15. Method according to claim 14, further comprising, between the step of depositing the gate material (224) and step c) of removing the exposed part (204b) of the organometallic layer (204), a step of removing a remaining part (220) of the resin layer (212) and oxidised parts (208b) of the semi-conductor layer (208).

16. Method according to one of claims 3 to 15, step d) of forming dielectric portions being obtained by the implementation of a step of depositing a first dielectric material (228) at least on the walls of the empty spaces formed by the removal of said exposed part (204b) of the organometallic layer (204) and a step of depositing a second dielectric material (232), different to the first dielectric material (228), in the remaining space of said empty spaces.

17. Method according to claim 16, the first and second dielectric materials (228, 232) deposited to form the dielectric portions also being deposited around the gate (224), thus forming spacers (228, 230).

18. Method according to one of preceding claims, the stack formed in step a) further comprising a second dielectric layer arranged between the substrate (102, 202) and the organometallic layer (104, 204).

19. Method according to one of preceding claims, further comprising, after step d) of forming dielectric portions (120, 124, 228, 232), a step of forming at least one electric contact (240) through at least the dielectric layer (106, 206) and the gate (116, 224) of the transistor (100, 200) , connected to the portions of organometallic material (104a, 204a).

## Patentansprüche

1. Herstellungsverfahren eines Transistor (100, 200) mit Selbstjustierung von Gate (116, 224) und Grundplatte (104a, 204a), das wenigstens die folgenden Schritte umfasst:
a) Herstellung eines Stapels auf einer Fläche eines Substrats (102, 202) auf der Basis wenigstens eines Halbleiters, umfassend wenigstens eine Schicht (104, 204) auf der Basis wenigstens eines organometallischen Materials und eine Schicht (106, 206) auf der Basis wenigstens eines auf der organometallischen Schicht (104, 204) abgeschiedenen dielektrischen Materials und dazu bestimmt, eine vergrabene Isolierschicht des Transistors (100, 200) zu bilden,
b) Elektronenstrahlbelichtung wenigstens eines Teils (104b, 204b) der organometallischen Schicht (104, 204), wobei ein bestimmtes Teilstück (104a, 204a) des belichteten Teils (104b, 204b) der organometallischen Schicht (104, 204), dazu bestimmt, die Grundplatte des Transistors (100, 200) zu bilden, während dieses Belichtungsschritts durch eine Maske (116, 213) gegen die Elektronenstrahlen geschützt ist, und die Form und die Abmessungen einer Sektion des Gates (116, 224) des Transistors (100, 200) - in einer im Wesentlichen zu der Fläche des Substrats (102, 202) parallelen Ebene - dazu bestimmt ist, im Wesentlichen der Form und den Abmessungen einer Sektion des genannten Teilstücks (104a, 204a) aus organometallischem Material in der genannten Ebene zu entsprechen,
c) Beseitigung des belichteten Teils (104b, 204b) der organometallischen Schicht (104, 204),
d) Herstellung von dielektrischen Teilstücken (120, 124, 228, 232) in den durch die Beseitigung des genannten belichteten Teils gebildeten Leerräumen (104b, 204b) der organometallischen Schicht (104, 204), zwischen der Fläche des Substrats (102, 202) und der dielektrischen Schicht (106, 206), um das genannte Teilstück (104a, 204a) der organometallischen Schicht (104, 204) herum.

2. Verfahren nach Anspruch 1, wobei der in Schritt a) realisierte Stapel außerdem eine Schicht (108, 208) auf der Basis von wenigstens einem Halbleiter umfasst, so dass die dielektrische Schicht (106, 206) zwischen der genannten Halbleiterschicht (108, 208) und der organometallischen Schicht (104, 204) angeordnet ist.

3. Verfahren nach Anspruch 2, außerdem umfassend - zwischen dem Stapelherstellungsschritt a) und dem Belichtungsschritt b) - einen Schritt zur Realisierung des Gates (116) des Transistors (100) auf der Halbleiterschicht (108), wobei das Gate (116) die Maske
bildet, die das Teilstück (104a) der organometallischen Schicht (104) während des Belichtungsschritts schützt.

4. Verfahren nach Anspruch 3, außerdem umfassend - zwischen Herstellungsschritt des Gates (116) des Transistors (100) und dem Belichtungsschritt b) - einen Schritt zur Abscheidung einer Fotoresistschicht (112) wenigstens auf dem Gate (116) und auf der Halbleiterschicht (108), und einen Schritt zur mechanisch-chemischen Planarisierung der Resistschicht (112) mit Stopp auf dem Gate (116).

5. Verfahren nach Anspruch 2, außerdem umfassend - zwischen dem Stapelherstellungsschritt a) und dem Belichtungsschritt b) - einen Schritt zur Abscheidung einer Fotoresistschicht (112) wenigstens auf der Halbleiterschicht (108) des Stapels, wobei in Schritt b) ebenfalls ein Teil (112a) der Fotoresistschicht (112) belichtet wird.

6. Verfahren nach Anspruch 5, außerdem umfassend - zwischen dem Belichtungsschritt b) und dem Schritt c) zur Beseitigung des belichteten Teils (104b) der organometallischen Schicht (104) - einen Schritt zur Beseitigung des belichteten Teils (112a) der Fotoresistschicht (112), so dass in der Resistschicht (112) ein Hohlraum entsteht, sodann Realisierung des Gates (116) durch wenigstens einen Schritt zur Abscheidung wenigstens eines Gatematerials in dem genannten Hohlraum und auf der Resistschicht (112) und einen Schritt zur mechanisch-chemischen Planarisierung mit Stopp auf der Resistschicht (112).

7. Verfahren nach Anspruch 4 oder 6, außerdem umfassend - zwischen dem mechanisch-chemischen Planarisierungsschritt und dem Schritt c) zur Beseitigung des belichteten Teils (104b) der organometallischen Schicht (104) - einen Schritt zu Beseitigung des belichteten Teils (112a) der Resistschicht (112).

8. Verfahren nach Anspruch 2, wobei der in Schritt a) realisiert Stapel außerdem eine Fotoresistschicht (212) umfasst, so dass die Halbleiterschicht (208) zwischen der genannten Resistschicht (212) und der dielektrischen Schicht (206) angeordnet ist.

9. Verfahren nach Anspruch 8, außerdem umfassend - zwischen dem Stapelherstellungsschritt a) und dem Belichtungsschritt b) - einen Schritt zur Realisierung, auf der Fotoresistschicht (212), der Maske (213), dazu bestimmt, das Teilstück (204a) der organometallischen Schicht (204) während des Belichtungsschritts b) zu schützen.

10. Verfahren nach Anspruch 9, wobei in dem Belichtungsschritt b), in dem ebenfalls ein Teil (212a) der Fotoresistschicht (212) belichtet wird, ein Teilstück (212b) der Fotoresistschicht (212), verschieden von dem genannten Teil (212a) der Fotoresistschicht (212), während dieses Belichtungsschritts durch die Maske (213) gegen die Elektronenstrahlen geschützt ist, und die Form und die Abmessungen einer Sektion - in einer im Wesentlichen zu der Fläche des Substrats (202) parallelen Ebene - des Gates (224) des Transistors (200) im Wesentlichen gleich der Form und den Abmessungen einer Sektion des genannten Teilstücks (212b) der Fotoresistschicht (212) in der genannten Ebene ist.

11. Verfahren nach Anspruch 10, außerdem umfassend - zwischen dem Belichtungsschritt b) und dem Schritt c) zur Beseitigung des belichteten Teils (204b) der organometallischen Schicht (204) - einen Schritt zur Beseitigung des nicht-belichteten Teils (212b) der Fotoresistschicht (212).

12. Verfahren nach Anspruch 11, außerdem umfassend - zwischen dem Schritt zur Beseitigung des nicht-belichteten Teils (212b) der Fotoresistschicht (212) und dem Schritt c) zur Beseitigung des belichteten Teils (204b) der organometallischen Schicht (204) - einen Schritt zur Realisierung wenigstens eines Spacers (214) gegen die Seitenwände eines Hohlraums, ausgebildet in der Resistschicht (212) durch die Beseitigung des nicht-belichteten Teils (212b) der Resistschicht (212), wobei dieser Spacer (214) dazu bestimmt ist, eine Kontur des Gates (224) des Transistors (200) zu bilden.

13. Verfahren nach Anspruch 12, außerdem umfassend - zwischen dem Schritt zur Herstellung des Spacers (214) in dem in der Resistschicht (212) ausgebildeten Hohlraum und dem Schritt c) zur Beseitigung des belichteten Teils (204b) der organometallischen Schicht (204) - einen Schritt zur Realisierung einer Hartmaske (216) gegenüber einem Teil der Halbleiterschicht (208), dazu bestimmt, Source(226a)-, Drain(226b)- und Kanal(226c)-Bereiche des Transistors (200) zu umfassen, einen Schritt zur Beseitigung der nicht durch die Hartmaske (216) bedeckten Teile der Resistschicht (212), sodann einen Schritt zur Oxidation von nicht durch die Hartmaske (216) bedeckten Teilen (208b) der Halbleiterschicht (208).

14. Verfahren nach Anspruch 13, außerdem umfassend - zwischen dem Schritt zur Oxidation der nicht durch die Hartmaske (216) bedeckten Teile (208b) der Halbleiterschicht (208) und dem Schritt c) zur Beseitigung des belichteten Teils (204b) der organometallischen Schicht (204) - einen Schritt zur Beseitigung der Hartmaske (216), sodann einen Schritt zu Abscheidung wenigstens eines Gatematerials (224) wenigstens innerhalb der durch den Spacer (214) gebildeten Kontur, derart das Gate (224) des Transistors (200) ausbildend.

15. Verfahren nach Anspruch 14, außerdem umfassend - zwischen dem Gatematerial-Abscheidungsschritt (224) und dem Schritt c) zur Beseitigung des belichteten Teils (204b) der organometallischen Schicht (204) - einen Schritt zur Beseitigung eines restlichen Teils (220) der Resistschicht (212) und der oxidierten Teile (208b) der Halbleiterschicht (208).

16. Verfahren nach einem der Ansprüche 3 bis 15, wobei der Schritt d) zur Herstellung dielektrischer Teilstücke realisiert wird durch die Ausführung eines Schritts zur Abscheidung eines ersten dielektrischen Materials (228) wenigstens auf den Wänden der durch die Beseitigung des genannten belichteten Teils (204b) der organometallischen Schicht (204) gebildeten Leerräume, und einen Schritt zur Abscheidung eines von dem ersten dielektrischen Material (228) verschiedenen zweiten dielektrischen Materials (232) in dem restlichen Raum der genannten Leerräume.

17. Verfahren nach Anspruch 16, wobei das erste und das zweite dielektrische Material (228, 232) , abgeschieden um die dielektrischen Teilstücke zu bilden, ebenfalls um das Gate (224) herum abgeschieden wird, derart Spacer (228, 230) ausbildend.

18. Verfahren nach einem der vorhergehenden Ansprüche, wobei der in Schritt a) realisierte Stapel außerdem eine zweite dielektrische Schicht umfasst, abgeschieden zwischen dem Substrat (102, 202) und der organometallischen Schicht (104, 204).

19. Verfahren nach einem der vorhergehenden Ansprüche, außerdem nach dem Schritt d) zur Realisierung der dielektrischen Teilstücke (120, 124, 228, 232) umfassend: einen Schritt zur Realisierung wenigstens eines mit dem Teilstück aus organometallischem Material (104a, 204a) verbundenen elektrischen Kontakts (240) durch wenigstens die dielektrische Schicht (106, 206) und das Gate (116, 224) des Transistors (100, 200) hindurch.
